Europäisches Patentamt

European Patent Office

Office européen des brevets

(19)

(11) Publication number : **0 301 956 B1**

(12)                    EUROPEAN PATENT SPECIFICATION

(45) Date of publication of patent specification :
**18.03.92 Bulletin 92/12**

(51) Int. Cl.⁵ : **A23L 2/04, A23L 2/08,
A23L 1/327, A23L 1/212,
A23L 3/00**

(21) Application number : **88401939.9**

(22) Date of filing : **26.07.88**

(54) **Method for processing food.**

The file contains technical information
submitted after the application was filed and
not included in this specification

(30) Priority : **28.07.87 JP 188596/87**

(43) Date of publication of application :
**01.02.89 Bulletin 89/05**

(45) Publication of the grant of the patent :
**18.03.92 Bulletin 92/12**

(84) Designated Contracting States :
**AT BE CH DE ES FR GB IT LI NL SE**

(56) References cited :
**BE-A- 660 431**

(56) References cited :
**US-A- 4 139 647
PATENT ABSTRACTS OF JAPAN, vol. 12, no.
143 (C-492)[2990] 30th April 1988; & JP-A-62
259 568 (EHIME PREF GOV SEIKA NOGYO
KYODO KUMIAI RENGOKAI) 11-11-1987
DERWENT, abstract no. 75-56830W (34); &
SU-A-454 890 (KRADS FOOD INDS) 21-02-1975**

(73) Proprietor : **SHONAN KORYO CORPORATION
25-10 Egota 1-chome
Nakano-Ku Tokyo 165 (JP)**

(72) Inventor : **Nozaka, Tooru
25-10 Egota 1-chome
Nakano-Ku Tokyo (JP)**

(74) Representative : **Hirsch, Marc-Roger
Cabinet Hirsch 34 rue de Bassano
F-75008 Paris (FR)**

EP 0 301 956 B1

## Description

The present invention relates to a method for processing prepared materials of fruits, vegetables and fishery products, and especially to a method using physical steps.

Hitherto, in the process of fruits, vegetables and fishery products, many kinds of methods have been used to prevent oxidation of processed materials or propagation of micro-organisms and to protect them from deterioration. Chemical methods such as addition of sulfur dioxide, ascorbic acid or ethanol are used. However, these compounds create problems because their kinds and quantity should be used properly according to the properties of materials, objects, environment for use, and so on. There are also problems about these compounds by which tastes, flavors and the like are changed during the process, and the natural flavors lost. As a result, it is impossible to use them widely. Physical methods such as a vacuum method or an inert gas substitution method have been partially tried. However, the vacuum method has a drawback since the flavors are volatilized. The inert gas substitution method has a drawback since it is difficult to obtain sufficiently low enough oxygen partial pressure to prevent oxidation.

Accordingly, there are no treatment methods for keeping natural flavors of fruits, vegetables or fishery products and conducting sufficient anti-oxidant at the present time.

The present inventor has thoroughly studied a method in which the above problems are wholly solved, processed materials keep their natural flavors, and oxidation of the materials and propagation of micro-organisms are sufficiently prevented. As a result, an effective physical means has been developed by which prepared materials such as fruits, vegetables and fishery products are processed under a nitrogen gas atmosphere by adding a given pressure, and has led to the present invention.

The present invention is a method for processing food, characterized in that prepared materials of fruits, vegetables or fishery products are processed under a nitrogen gas atmosphere at a gauge pressure of 150 kPa and more by using at least one or more steps selected from crush, extraction, squeeze, filtration and concentration operations.

The fruits used in the present invention do not have to be particularly limited, and fruits that are raw materials of unrefined products, puree, fruit wine (must) or fruit juice can be used.

Similarly, the vegetables from which puree, vegetable juice and the like are available do not have to be particularly limited.

The fishery products used in the present invention can contain not only fresh sea food but also processed goods such as dried bonito which is extraction material.

The prepared materials used in the present invention contain fruits, vegetables and fishery products obtained by washing, selecting and then removing their skin or seeds.

The steps for proceeding with these prepared materials suitable for use in the present invention are as follows.

Firstly, the prepared materials are chopped with a crusher or a cutter to obtain crushed materials. The crushed materials are put into a grinding mill and grinded; and mash is obtained. The mash is treated with a pulper and is strained, and puree is obtained. Alternatively the mash is treated with a squeezer and fruit juice is obtained, the juice being must for wine. Then, the juice is treated with a centrifugal separator, the liquid obtained is treated with an ultrafilter (UF) and transparent filtrate (clear fruit juice) is obtained. Otherwise, the centrifuged liquid is treated with a reverse osmosis (RO) dehydrator and concentrated liquid (concentrated fruit juice) is obtained. Furthermore, an extract of sea food is generally obtained by extraction in hot water. Namely, fishery products such as dried bonitos, oysters and the like are dipped into hot water, and then filtered. The obtained filtrate is treated with a reverse osmosis dehydrator and concentrated extract is obtained.

In the present invention, the prepared materials are processed by using one or more steps, such as the crushing or chopping of the prepared materials, the grinding of the crushed materials, the straining or squeezing of the mash, the centrifugation of juice, the filtration or dehydration of the juice obtained by the centrifugation, the hot water extraction of the prepared materials and the like, under inert gas conditions, preferably in an atmosphere of nitrogen gas at a gauge pressure of 150 kPa and more, preferably 150 kPa - 12 MPa. Practically, devices which are not closed in themselves, such as a crusher, a chopper, a cutter, a squeezer and the like, can be closed with covers, and devices which are closed in themselves, such as a grinding mill, a centrifugal separator, an ultrafilter, a reverse osmosis dehydrator and the like, can be used as such and nitrogen gas can be injected under pressure. These devices are preferably connected with pipes and a closed system is maintained. When the system is maintained under a nitrogen gas atmosphere at a gauge pressure of 150 kPa and more, the relative oxygen concentration in the gas which remains in the process materials falls sharply. When the gauge pressure is less than 150 kPa, the purpose of the present invention can not be attained. When the gauge pressure is over 12 MPa, the device becomes overloaded and it can reveal prejudiciable.

By using the present invention which is constituted as described above, the following effects are obtained.

(1) As the food is treated under a nitrogen gas atmosphere at a constant pressure, the partial pressure of oxygen is considerably decreased in the process system, and the oxygen concentration of the gas which is dissolved in the processed materials is considerably decreased. As a result, the oxidation of the process materials and the undesirable propagation of micro-organisms can be prevented.

(2) As the nitrogen gas release continues from the process materials under reduced pressure, the oxidation of the process materials can be continuously prevented in a stable atmosphere.

(3) As the process is conducted in a closed system, and merely the nitrogen gas is allowed dissolution in the process materials, the natural flavor of food is not lost.

As described above, the present invention is used widely and exerts its effect. Furthermore, the present invention is applicable to the obtention of human or animal medicines, agricultural medicines, dyes and the like not only by treating fruits, vegetables and fishery products, but also by treating medical plants, wild plants, fungi and the like.

The following examples illustrate the present invention more specifically.

EXAMPLE 1

Prepared apples were treated with a crusher, and 10t of the crushed materials was put into a grinding mill which was maintained at a gauge pressure of 150 kPa under a nitrogen atmosphere. The ground materials were then pressed in a squeezer, which was connected with the grinding mill covered by a stainless steel airtight cover, and squeezed for two minutes. The squeezer was the screw press type, the retention volume was 300 kg and the treatment ability was 10 t/hour. The obtained juice was continuously treated with a centrifugal separator to control pulp content and 7.8 t of apple juice was obtained.

Comparison Example 1

In comparison with Example 1, about 7.7 t of apple juice was obtained by the same method as in example 1 except that the nitrogen gas pressure was maintained at 80 kPa.

One liter each of the juice obtained in example 1 (a sample of this invention) and the juice obtained in comparison example 1 (a sample of control) was drawn off to detect microorganisms by a sanitary test method agreed by Japanese Pharmaceutical Association, and a taste test (an organoleptic test) was conducted by an organoleptic panel of 24 persons. In the taste test, blind folded persons judged whether each sample was good or not, and these results were synthetically decided and marked with o = good and x = bad. The results are shown in Table 1.

TABLE 1

|  | | Sample of this invention | Sample of control |
| --- | --- | --- | --- |
| JAS* items: | Sugar | 10.6° BX | 10.6° BX |
|  | Acidity | 0.31% | 0.32% |
|  | Ash | 0.21% | 0.22% |
|  | Amino-N | 8.5 mg% | 8.5 mg% |
| Micro-organic test: | | | |
|  | General bacilli | 1200/ml | 3500/ml |
|  | Mold, Yeast | 450/ml | 1000/ml |
|  | Colitis germs | 81/ml | 150/ml |
| Organoleptic test: | | | |
|  | (persons/persons) | 20/24 | 4/24 |
| Synthetic judgement | | o | x |

*JAS: Japanese Agricultural Standard

EXAMPLE 2

Four tons of apple juice was pressed into a ultrafilter maintained at a gauge pressure of about 500 kPa under a nitrogen gas atmosphere.

The ultrafilter comprised 60 modules of tube membrane having an area of 1.6 m², a circulating pump and a tank, and the membrane area was 96 m². The flux was 35 1/m² hour and the filtration time was 1.2 hours. The total volume of the filtrate containing a liquid obtained by washing of pulp was 4.1 t.

Comparison Example 2

By the same method as that used in Example 1 (except that the nitrogen gas was absent) 3.9 t of the filtrate was obtained.

One liter each of the filtrate obtained in Example 2 and the filtrate obtained in comparison Example 2 was drawn off to test by the same method as described in comparison Example 1. The results are shown in Table 2.

TABLE 2

|  |  | Sample of this invention | Sample of control |
|---|---|---|---|
| JAS items: | Sugar | 9.6° BX | 9.5° BX |
|  | Acidity | 0.29% | 0.28% |
|  | Ash | 0.20% | 0.20% |
|  | Amino-N | 7.7 mg% | 7.5 mg% |
| Micro-organic test: |  |  |  |
|  | General bacilli | 18/ml | 79/ml |
|  | Mold, Yeast | 13/ml | 12/ml |
|  | Colitis germs | 11/ml | 15/ml |
| Organoleptic test: |  |  |  |
|  | (persons/persons) | 21/24 | 3/24 |
| Synthetic judgement |  | o | x |

EXAMPLE 3

Four tons of juice was pressed into a reverse osmosis dehydrator of the plate type which was maintained at a gauge pressure of about 12 MPa in a nitrogen atmosphere. The dehydrator was equipped with 150 m² of a membrane having high level rejection, and the flow rate was maintained by an external drive. The juice was treated at an initial flux of 20 l/m² hour, and a terminal flux of 5 l/m² hour for about one hour. When the concentration of the juice in the equipment attained the desired concentration (41° BX), the juice was removed. 0.5 t of the concentrated juice was obtained.

Comparison Example 3

For comparison, the nitrogen gas method was changed to a method using a common reverse osmosis dehydrator which was circulated by a pump in the usual atmosphere. However, the desired concentration of the juice in the equipment could not be obtained because the juice was fermented.

One liter of the concentrate which was obtained in Example 3 was drawn off and tested. The results are shown in Table 3.

4

TABLE 3

| JAS items: | Sample of this invention | Sample of control |
|---|---|---|
| Sugar | 41.2° BX | |
| Acidity | 1.25% | |
| Ash | 0.85% | Unmeasured |
| Amino-N | 33.2 mg% | |
| Micro-organic test: | | |
| General bacilli | 1300/ml | |
| Mold, Yeast | 15/ml | Unmeasured |
| Colitis germs | 120/ml | |
| Organoleptic test: | | |
| (persons/persons) | 24/24 | 0/24 |
| Synthetic judgement | o | x |

EXAMPLE 4

Dried bonito was extracted in hot water, and 8.5 t of the extract was filtered. The obtained filtrate was pumped into a reverse osmosis dehydrator of the spiral type which was maintained at about 5 MPa in a nitrogen gas atmosphere. The dehydrator was equipped with eight vessels each containing three 6.8 m$^2$ elements inside, a high pressure tank of full load type and a circulating pump, and the membrane area was 160 m$^2$. Then, the filtrate was treated at an initial flux of 15 l/m$^2$ hour and a terminal flux of 6 l/m$^2$ hour for 4.8 hours. 1.3 t of the concentrated extract was obtained.

Comparison Example 4

For comparison, the nitrogen gas pressure method was changed to a method using the common reverse osmosis dehydrator which was circulated by a pump in normal atmosphere. To prevent proliferation of micro-organisms, the dehydrator was maintained at temperatures of 15°C and 50°C, and the filtered extract was concentrated. The flux was 6l/m$^2$ hour in the treatment at 15°C and its decrease was considerable, and the deterioration of flavor was considerable in the treatment at 50°C, so that the obtained concentrate could not be put to practical use.

However, the concentrate obtained in Example 4 gave a good synthetic judgment because the proliferation of micro-organisms was low and the organoleptic test of the flavor showed 24/24. The results are shown in Table 4.

TABLE 4

| Item | Sample of this invention | Sample of control | |
|---|---|---|---|
| | | 50°C | 15°C |
| All solid Component % | 8.52 | 8.49 | 3.26 |
| All nitrogen % | 1.24 | 1.21 | 0.40 |
| Organoleptic test: | | | |
| (persons/persons) | 24/24 | 3/24 | -- |
| Synthetic judgement | o | x | x |

5

EXAMPLE 5

Twenty kilograms each of apples which were crushed along with 400 ppm of vitamin C was put into closed tanks (50 L volume) fitted with an agitator, and the atmosphere was replaced with nitrogen gas. The tanks were closed and maintained at gauge pressures of 0.00, 0.10, 0.17, 0.50, 1.50 and 3.00 MPa, respectively. Thereafter, the apples were ground fine and thoroughly mixed for 15 minutes, the tanks were opened under atmosphere pressure, and the degrees of browning were compared by determining their optical densities. The results are shown in Table 5.

As a result, the color change speeds decreased with increasing nitrogen gas pressures, and the effect was remarkable in pressures over 0.15 MPa.

TABLE 5

| $\Delta$OD | 0.10 | 0.15 | 0.25 | 0.35 |
|---|---|---|---|---|
| Nitrogen pressure (MPa) | Time up to the extent of $\Delta$OD value (hour) | | | |
| 0.00 | 2.00 | 2.22 | 2.68 | 3.12 |
| 0.10 | 2.38 | 2.80 | 3.22 | 3.62 |
| 0.17 | 2.97 | 3.28 | 3.68 | 4.22 |
| 0.50 | 3.33 | 3.73 | 4.38 | 4.97 |
| 1.50 | 3.80 | 4.50 | 5.67 | 6.68 |
| 3.00 | 4.38 | 5.33 | 7.12 | 8.32 |

In addition, the $\Delta$OD value of the sample in which the substitution of nitrogen gas was not conducted attained 0.35 within 13 minutes.

Fruits having live tissues are killed by crushing, and enzymic and nonenzymic changes of the fruits begin rapidly, and the fresh flavor is gradually lost. The degree of browning is an important index of the flavor. The value of $\Delta$OD = 0.15 shows a level in which the browning is observed with the naked eye and the value of $\Delta$OD = 0.35 shows a level in which the fresh flavor of apples is apparently lost.

The method for determining $\Delta$OD is as follows. The preparation method of samples: fruit juice and 95% ethanol were mixed in the ratio of 1:1 and filtered with Toyo filter paper No.2.

The determination: the sample was inserted in a 10 mm glass cell, and the absorbance was observed at 430 and 660 nm by using purified water as a control.

As the result, OD430 - OD660 = $\Delta$OD is obtained.

**Claims**

1. A process for processing food consisting in subjecting a food material, selected from the group consisting of fruit, vegetables and fishery products to processing steps comprising at least one of the steps consisting in crushing, extracting, filtering the juice and concentrating it, which steps are carried out under a nitrogen atmosphere at a gauge pressure of 150 kPa to 12 MPa.

**Patentansprüche**

1. Verfahren zur Behandlung von Nahrungsmitteln der Gruppe die Obst bzw. Früchte, Gemüse und Fischereiprodukte umfasst, bei dem wenigstens einer der folgenden Verfahrensschritte durengeführt wird: Zerkleinern, Extrahieren von Saft, Filtrieren und dann Konzentrieren des Safts, wobei diese Verfahrensschritte in einer Stickstoffatmosphäre unter einem Druck von 150 kPa bis 12 MPa durchgeführt werden.

**Revendications**

1. Un procédé de traitement de nourriture consistant à soumettre une nourriture choisie parmi le groupe consistant en fruits, légumes et produits de pêche à des étapes de traitement comprenant au moins une des étapes consistant en broyage, extraction, filtrage du jus et concentration de celui-ci, lesdites étapes étant mises en oeuvre sous une atmosphère d'azote à une pression de 150 kPa à 12 MPa.